(19) Europäisches Patentamt
European Patent Office
Office européen des brevets

(11) EP 3 162 852 A1

(12) EUROPEAN PATENT APPLICATION
published in accordance with Art. 153(4) EPC

(43) Date of publication:
**03.05.2017 Bulletin 2017/18**

(21) Application number: **15815263.7**

(22) Date of filing: **29.06.2015**

(51) Int Cl.:
***C08L 67/02*** (2006.01) ***C08G 63/199*** (2006.01)
***C08K 3/22*** (2006.01) ***C08K 7/10*** (2006.01)
***H01L 33/60*** (2010.01)

(86) International application number:
**PCT/JP2015/003260**

(87) International publication number:
**WO 2016/002193 (07.01.2016 Gazette 2016/01)**

(84) Designated Contracting States:
**AL AT BE BG CH CY CZ DE DK EE ES FI FR GB GR HR HU IE IS IT LI LT LU LV MC MK MT NL NO PL PT RO RS SE SI SK SM TR**
Designated Extension States:
**BA ME**
Designated Validation States:
**MA**

(30) Priority: **30.06.2014 JP 2014135027**

(71) Applicant: **Mitsui Chemicals, Inc.**
**Minato-ku**
**Tokyo 105-7122 (JP)**

(72) Inventors:
- **OHSHIMIZU, Kaoru**
  **Chiba 299-0265 (JP)**
- **OGASAWARA, Hideto**
  **Chiba 299-0265 (JP)**
- **EBATA, Hiroki**
  **Chiba 299-0265 (JP)**
- **HAMA, Takashi**
  **Chiba 299-0265 (JP)**

(74) Representative: **Hoffmann Eitle**
**Patent- und Rechtsanwälte PartmbB**
**Arabellastraße 30**
**81925 München (DE)**

# (54) POLYESTER RESIN COMPOSITION FOR REFLECTIVE MATERIALS AND REFLECTION PLATE CONTAINING SAME

(57) The purpose of the present invention is to provide a polyester resin composition for a reflection plate having high reflectance and small decrease of reflectance under exposure to heat during production of an LED package or reflow soldering step for mounting, or exposure to heat and light from a light source. A polyester resin composition of the present invention contains: 30-80% by mass of (A) a polyester resin having a melting point or glass transition temperature of 250 °C or more as measured by DSC; 5-30% by mass of (B) a fibrous reinforcing material having an average fiber length (1) of 2-300 μm, an average fiber diameter (d) of 0.05-18 μm and an aspect ratio (1/d) of 2-20, said aspect ratio being a quotient of 1 by d; and 5-50% by mass of (C) a white pigment (with the total of (A), (B) and (C) being 100% by mass).

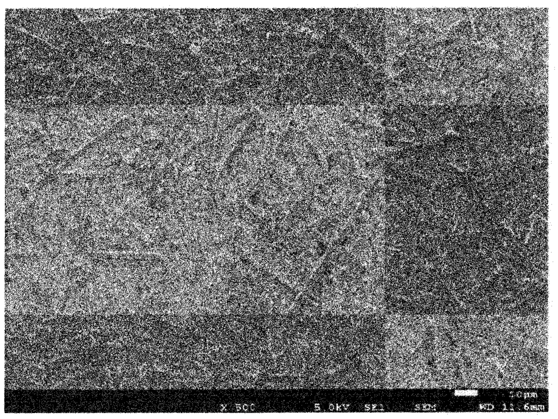

FIG. 1A

EP 3 162 852 A1

## Description

### Technical Field

The present invention relates to a polyester resin composition for a reflective material and a reflector including the same.

### Background Art

Light sources such as light-emitting diodes (LEDs) and organic ELs have been widely used as illumination, backlights of displays, and the like by making the best use of their characteristic features such as low power consumption and long life. For efficient utilization of light from these light sources, reflectors have been used in various situations.

For example, an LED package may be configured mainly from a housing composed of a substrate and a reflector integrally molded therewith, an LED disposed inside the housing, and a transparent sealing member sealing the LED. Such an LED package may be produced by the following steps: obtaining a housing composed of a reflector molded on a substrate; disposing an LED inside the housing and electrically connecting the LED with the substrate; and sealing the LED with a sealant. During the sealing, the LED package is heated at 100 to 200 °C for thermally curing the sealant, and therefore, reflectors need to maintain their reflectance even under such heating conditions. Further, during reflow soldering for mounting the LED package on a printed substrate, the LED package is exposed to a high temperature which is 250 °C or higher, and therefore, reflectors need to also maintain their reflectance under such an even higher temperature. Furthermore, under the operating environment, reflectors need to maintain their reflectance even after exposure to heat and light generated from LEDs.

Polyamide resin-containing materials are often used for such reflectors. However, a polyamide resin may suffer discoloration caused by terminal amino group or amide bond, and therefore, using a polyamide resin may cause a problem such as lowering of the reflectance of the reflectors. For solving such a problem, for example, improvement of base polymers by using a heat-resistant polyester (such as polycyclohexylenedimethylene terephthalate (PCT)) in place of a polyamide resin is under consideration for suppressing the lowering of the reflectance of the reflectors (PTL 1).

As a resin composition for a reflector which is suitable for a reflector of an LED or the like, there is proposed a resin composition for a reflector which contains a specific semi-aromatic polyamide, a specific amount of potassium titanate fiber and/or wollastonite (see PTL 2). It is disclosed that this resin composition for a reflector maintains advantageous physical properties of the semi-aromatic polyamide while being excellent in reflectance, whiteness, moldability, mechanical strength, dimensional stability, heat resistance, light shielding property, and hygroscopicity, particularly in light shielding property and, therefore maintains high whiteness without suffering discoloration even after exposure to high temperatures.

### Citation List

#### Patent Literature

PTL 1
Japanese Unexamined Patent Application Publication (Translation of PCT Application) No. 2009-507990
PTL 2
Japanese Patent Application Laid-Open No. 2002-294070

### Summary of Invention

#### Technical Problem

Reflectors obtained from heat-resistant polyesters and polyamide resin compositions as described in PTLs 1 and 2 do not have satisfactorily high reflectance. Further, the reflector of PTL 2 does not have satisfactory heat resistance, and the reflectors of PTLs 1 and 2 are incapable of satisfactorily suppressing discoloration or the like caused by visible light or ultraviolet light and, therefore, are incapable of satisfactorily suppressing the lowering of reflectance after exposure to heat and/or light.

Further, in accordance with increase in luminescence of LEDs, there is a demand for, for example, further improvements in both whiteness and reflectance of reflectors used for LEDs.

The present invention has been made under the above circumstances, and an object of the present invention

is to provide a polyester resin composition which enables a production of a reflector having high reflectance, together with reduced lowering of reflectance even after exposure to heat during production of a LED package or reflow soldering at the time of mounting, or to heat and light generated from a light source under the operating environment.

Solution to Problem

[1] A polyester resin composition for a reflective material, comprising: 30 to 80 mass% of a polyester resin (A) which has a melting point (Tm) or a glass transition temperature (Tg) of 250°C or higher as measured by means of a differential scanning calorimeter (DSC); 5 to 30 mass% of a fibrous reinforcing material (B) which has an average fiber length (1) of 2 to 300 $\mu$m, an average fiber diameter (d) of 0.05 to 18 $\mu$m, and an aspect ratio (1/d) of 2 to 20 which is obtained by dividing the average fiber length (1) by the average fiber diameter (d); and 5 to 50 mass% of a white pigment (C), total of components (A), (B) and (C) being 100 mass%.

[2] The polyester resin composition for a reflective material according to [1], wherein the fibrous reinforcing material (B) has the average fiber length (1) of 8 to 100 $\mu$m, the average fiber diameter (d) of 2 to 6 $\mu$m, and the aspect ratio (1/d) of 4 to 16.

[3] The polyester resin composition for a reflective material according to [1] or [2], wherein the polyester resin (A) contains: a dicarboxylic acid component unit (a1) containing 30 to 100 mol% of a dicarboxylic acid component unit derived from terephthalic acid, and 0 to 70 mol% of an aromatic dicarboxylic acid component unit derived from an aromatic dicarboxylic acid exclusive of terephthalic acid; and a dialcohol component unit (a2) containing a $C_4$-$C_{20}$ alicyclic dialcohol component unit and/or an aliphatic dialcohol component unit.

[4] The polyester resin composition for a reflective material according to [3], wherein the alicyclic dialcohol component unit has a cyclohexane skeleton.

[5] The polyester resin composition for a reflective material according to [3] or [4], wherein the dialcohol component unit (a2) contains 30 to 100 mol% of a cyclohexanedimethanol component unit and 0 to 70 mol% of the aliphatic dialcohol component unit.

[6] The polyester resin composition for a reflective material according to any one of [1] to [5], wherein the fibrous reinforcing material (B) is wollastonite.

[7] The polyester resin composition for a reflective material according to any one of [1] to [6], wherein a content of the white pigment (C) is 10 to 40 mass% based on the total of (A), (B) and (C).

[8] A reflector obtained by molding the polyester resin composition for a reflective material according to any one of [1] to [7].

[9] The reflector according to [8] which is a reflector for a light-emitting diode element.

Advantageous Effects of Invention

The polyester resin composition of the present invention can provide a reflector which has high reflectance, and which at the same time, maintains high whiteness while suppressing discoloration to a low level and reduces the lowering of reflectance even when exposed to not only heat during production of an LED package or reflow soldering at the time of mounting of the LED package, but also heat and light generated from an LED element under the operating environment.

Brief Description of Drawings

FIG. 1A is an SEM image of a pellet-shaped polyester resin composition of Example 1;

FIG. 1B is an SEM image of a molded product of the pellet-shaped polyester resin composition of Example 1;

FIG. 2A is an SEM image of a pellet-shaped polyester resin composition of Comparative Example 1; and

FIG. 2B is an SEM image of a molded product of the pellet-shaped polyester resin composition of Comparative Example 1.

Description of Embodiments

The present inventors have found that by using a fibrous reinforcing material (B) having an average fiber length (1) at or below a predetermined value in a polyester resin composition for a reflective material, it becomes possible to obtain a molded product having an increased reflectance and reduced lowering of reflectance caused by heat and/or light.

The reason for the above advantageous effects is not clear, but it can be presumed as follows. A polyester resin (A) such as PCT has a high melting point, but on the other hand, the polyester resin (A) requires a high melting temperature or long residence time in a molding machine for obtaining pellets or a molded product. Therefore, when a resin composition containing the polyester resin (A) is melt-kneaded for producing a resin composition in a pellet form or for molding into a molded product, the polyester resin (A) is likely to receive excess shear stress at high temperature, thereby suffering from heat decomposition. At this time, when the fibrous reinforcing material (B) contained in the polyester resin composition have an average fiber length (1) at or below a predetermined value, the fibrous reinforcing material (B) is capable of uniformly and finely dispersing in the polyester resin (A). As a result, the fibrous reinforcing material (B) functions as a cushioning material (buffer material), thereby reducing the excess shear stress applied to the polyester resin (A) during the production or molding of the resin composition, and suppressing the heat decomposition of the polyester resin (A). Accordingly, a molded product with high whiteness and reflectance can be obtained. Further, a molded product containing the fibrous reinforcing material (B) having an average fiber diameter (d) at or below a predetermined value also has high surface smoothness, and thus is likely to exhibit high reflectance.

The fibrous reinforcing material (B) having an average fiber length (1) at or below a predetermined value is uniformly and finely dispersed in a molded product, and thus can block heat and light satisfactorily. As a result, it becomes possible to suppress heat and light deterioration of the polyester resin (A) contained in the molded product, and to reduce the lowering of reflectance. Furthermore, the fibrous reinforcing material (B) having an average fiber length (1) at or below a predetermined value can suppress the generation of gaps (voids) around the fibrous reinforcing material (B) caused by the difference in the thermal conductivity as between the polyester resin (A) and the fibrous reinforcing material (B) both contained in the molded product. As a result, it becomes possible to reduce light scattering caused by the voids, and reduce the lowering of the reflectance even further. The present invention has been made on the basis of such findings.

1. Polyester Resin Composition for a Reflective Material

The polyester resin composition of the present invention for a reflective material contains a polyester resin (A), a fibrous reinforcing material (B), and a white pigment (C).

1-1. Polyester Resin (A)

The polyester resin (A) preferably contains at least a dicarboxylic acid component unit (a1) containing a component unit derived from an aromatic dicarboxylic acid, and a dialcohol component unit (a2) containing a component unit derived from a dialcohol having an alicyclic skeleton.

The dicarboxylic acid component unit (a1) constituting the polyester resin (A) preferably contains 30 to 100 mol% of a terephthalic acid component unit, and 0 to 70 mol% of an aromatic dicarboxylic acid component unit derived from an aromatic dicarboxylic acid exclusive of terephthalic acid. The total amount of the dicarboxylic acid component units in the dicarboxylic acid component unit (a1) is 100 mol%.

The proportion of the terephthalic acid component unit in the dicarboxylic acid component unit (a1) is more preferably 40 to 100 mol%, and can be still more preferably 60 to 100 mol%. The heat resistance of the polyester resin (A) is likely to become improved when the proportion of the terephthalic acid component unit is at or above a predetermined value. The proportion of the aromatic dicarboxylic acid component unit, which is derived from an aromatic dicarboxylic acid exclusive of terephthalic acid, in the dicarboxylic acid component unit (a1) is more preferably 0 to 60 mol%, and can be still more preferably 0 to 40 mol%.

The terephthalic acid component unit may be a component unit derived from terephthalic acid or a terephthalic acid ester. The terephthalic acid ester is preferably a $C_1$-$C_4$ alkyl ester of terephthalic acid, and an example of such a terephthalic acid ester is dimethyl terephthalate.

Preferred examples of the aromatic dicarboxylic acid component units derived from an aromatic dicarboxylic acid exclusive of terephthalic acid include component units derived from isophthalic acid, 2-methyl terephthalic acid, naphthalene dicarboxylic acid and the combinations thereof, and component units derived from esters of these aromatic dicarboxylic acids (preferably $C_1$-$C_4$ alkyl esters of the aromatic dicarboxylic acids).

The dicarboxylic acid component unit (a1) may further contain a small amount of an aliphatic dicarboxylic acid component unit or a polycarboxylic acid component unit in addition to the above constituent units. The total proportion of the aliphatic dicarboxylic acid component unit and the polycarboxylic acid component unit in the dicarboxylic acid component unit (a1) can be, e.g., 10 mol% or less.

The number of carbon atoms of the aliphatic dicarboxylic acid component unit is not particularly limited, but is preferably 4 to 20, and more preferably 6 to 12. Examples of aliphatic dicarboxylic acids used for deriving the aliphatic dicarboxylic acid component units include adipic acid, suberic acid, azelaic acid, sebacic acid, decane dicarboxylic acid, undecane dicarboxylic acid, and dodecane dicarboxylic acid; and adipic acid may be preferred. Examples of the polycarboxylic acid component units include tribasic acids and polybasic acids, such as trimellitic acid and pyromellitic acid.

The dialcohol component unit (a2) constituting the polyester resin (A) preferably contains an alicyclic dialcohol component unit. The alicyclic dialcohol component unit preferably contains a component unit derived from a dialcohol having a $C_4$-$C_{20}$ alicyclic hydrocarbon skeleton. Examples of the dialcohols having an alicyclic hydrocarbon skeleton include alicyclic dialcohols such as 1,3-cyclopentanediol, 1,3-cyclopentanedimethanol, 1,4-cyclohexanediol, 1,4-cyclohexanedimethanol, 1,4-cycloheptanediol, and 1,4-cycloheptanedimethanol. Among these compounds, in view of heat resistance, water absorption properties, availability, and the like, a component unit derived from a dialcohol having a cyclohexane skeleton is preferred, and a component unit derived from cyclohexanedimethanol is more preferred.

While the alicyclic dialcohol has isomers of cis/trans configuration or the like, the trans configuration is preferred in view of heat resistance. Accordingly, the cis/trans ratio is preferably 50/50 to 0/100, and more preferably 40/60 to 0/100.

For increasing the melt-flowability or the like of the resin, the dialcohol component unit (a2) may further contain an aliphatic dialcohol component unit in addition to the alicyclic dialcohol component unit. Examples of aliphatic dialcohols include ethylene glycol, trimethylene glycol, propylene glycol, tetramethylene glycol, neopentyl glycol, hexamethylene glycol, and dodecamethylene glycol.

The dialcohol component unit (a2) constituting the polyester resin (A) preferably contains 30 to 100 mol% of the alicyclic dialcohol component unit (preferably the dialcohol component unit having a cyclohexane skeleton), and 0 to 70 mol% of the aliphatic dialcohol component unit. The total amount of the dialcohol component units in the dialcohol component unit (a2) is 100 mol%.

The proportion of the alicyclic dialcohol component unit (preferably the dialcohol component unit having a cyclohexane skeleton) in the dialcohol component unit (a2) is more preferably 50 to 100 mol%, and can be still more preferably 60 to 100 mol%. The proportion of the aliphatic dialcohol component unit in the dialcohol component unit (a2) is more preferably 0 to 50 mol%, and can be still more preferably 0 to 40 mol%.

The dialcohol component unit (a2) may further contain a small amount of an aromatic dialcohol component unit in addition to the above constituent units. Examples of the aromatic dialcohols include aromatic diols such as bisphenols, hydroquinones, and 2,2-bis(4-β-hydroxyethoxy phenyl)propane.

The melting point (Tm) or a glass transition temperature (Tg) of the polyester resin (A) is 250°C or higher as measured by means of a differential scanning calorimeter (DSC). The lower limit of the melting point (Tm) or glass transition temperature (Tg) is preferably 270 °C, and more preferably 290 °C. On the other hand, a preferred upper limit of the melting point (Tm) or glass transition temperature (Tg) is, e.g., 350 °C, and more preferably 335 °C. When the melting point or glass transition temperature is 250 °C or higher, the discoloration or deformation of a reflector (molded product of the resin composition) during reflow soldering can be suppressed. While, in principle, there is no limitation to the upper limit of the temperature, the melting point or glass transition temperature of 350 °C or lower is preferred for suppressing the decomposition of the polyester resin (A) during melt molding.

For example, the melting point (Tm) or glass transition temperature (Tg) of the polyester resin (A) is within a range of 270 to 350 °C, and preferably within a range of 290 to 335 °C.

The melting point of the polyester resin (A) can be measured by means of a differential scanning calorimeter (DSC) in accordance with JIS-K7121. Specifically, X-DSC7000 (manufactured by SII) is provided as a measuring apparatus. A sample of the polyester resin (A) sealed in a pan for DSC measurement is set in the apparatus, and the temperature is elevated to 320 °C at a temperature-elevation rate of 10 °C/min in a nitrogen atmosphere, maintained thereat for 5 minutes, and then lowered to 30 °C at a temperature-lowering rate of 10 °C/min. The peak top temperature of an endothermic peak during the temperature elevation is used as a "melting point."

The intrinsic viscosity [η] of the polyester resin (A) is preferably 0.3 to 1.2 dl/g. When the intrinsic viscosity is in the above-mentioned range, the flowability during molding of the polyester resin composition for a reflective material becomes excellent. The intrinsic viscosity of the polyester resin (A) can be adjusted by, e.g., adjusting the molecular weight of the polyester resin (A). The molecular weight of the polyester resin (A) can be adjusted by a conventional method, such as adjustment of the degree of progress of a polycondensation reaction, or addition of an adequate amount of a monofunctional carboxylic acid, a monofunctional alcohol, or the like.

The intrinsic viscosity of a polyester resin (A) can be measured by the following steps.

A polyester resin (A) is dissolved in 50/50 mass% mixed solvent of phenol and tetrachloroethane to obtain a sample solution. The falling time (seconds) of the obtained sample solution is measured using an Ubbelohde viscometer at 25 °C ± 0.05 °C, and the intrinsic viscosity [η] is calculated by applying the results to the following equations.

$$[\eta] = \eta SP/[C(1+k\eta SP)]$$

[η]: intrinsic viscosity (dl/g)
ηSP: specific viscosity
C: sample concentration (g/dl)

t: falling time (seconds) of sample solution
t0: falling time (seconds) of a solvent
k: constant (slope determined by measuring the specific viscosity of (3 or more) samples having different solution concentrations, and plotting ηSP/C on the abscissa against the solution concentration of the ordinate)

$$\eta SP = (t - t0)/t0$$

A polyester resin (A) can be obtained by, e.g., reacting a dicarboxylic acid component unit (a1) and a dialcohol component unit (a2) with a molecular weight modifier or the like blended into a reaction system. As described above, the intrinsic viscosity of the polyester resin (A) can be adjusted by blending a molecular weight modifier into the reaction system.

The molecular weight modifier may be a monocarboxylic acid or a monoalcohol. Examples of the monocarboxylic acids include $C_2$-$C_{30}$ aliphatic monocarboxylic acids, aromatic monocarboxylic acids and alicyclic monocarboxylic acids. The aromatic monocarboxylic acid and the alicyclic monocarboxylic acid may have a substituent in the cyclic structure thereof. Examples of the aliphatic monocarboxylic acids include acetic acid, propionic acid, butyric acid, valeric acid, caproic acid, caprylic acid, lauric acid, tridecyl acid, myristic acid, palmitic acid, stearic acid, oleic acid, and linoleic acid. Examples of the aromatic monocarboxylic acids include benzoic acid, toluic acid, naphthalene carboxylic acid, methylnaphthalene carboxylic acid, and phenylacetic acid, and an example of the alicyclic monocarboxylic acid is cyclohexane carboxylic acid.

The amount of the molecular weight modifier added may be 0 to 0.07 moles, and preferably 0 to 0.05 moles, relative to total 1 mole of the dicarboxylic acid component unit (a1) used in the reaction between the dicarboxylic acid component unit (a1) and the dialcohol component unit (a2).

The content of the polyester resin (A) in the polyester resin composition of the present invention for a reflective material is preferably 30 to 80 mass%, more preferably 30 to 70 mass%, and still more preferably 40 to 60 mass%, relative to the total amount of the polyester resin (A), a fibrous reinforcing material (B), and a white pigment (C). When the content of the polyester resin (A) is at or above a predetermined value, it is more likely to obtain a polyester resin composition for a reflective material having excellent heat resistance which enables the composition to withstand reflow soldering without impairing moldability.

The polyester resin composition of the present invention for a reflective material may further contain one or more polyester resins having different physical properties as necessary.

1-2. Fibrous Reinforcing Material (B)

The fibrous reinforcing material (B) in the polyester resin composition of the present invention for a reflective material can impart strength, rigidity, toughness and the like to a molded product obtained. Examples of the fibrous reinforcing materials (B) include glass fiber, wollastonite, potassium titanate whisker, calcium carbonate whisker, aluminum borate whisker, magnesium sulfate whisker, sepiolite, xonotlite, zinc oxide whisker, milled fiber, and cut fiber. These may be used individually or in combination. Among these, preferred is at least one member selected from the group consisting of wollastonite and potassium titanate whisker, and this is due to their relatively small average fiber diameter (d), capability of increasing surface smoothness of a molded product, and the like. More preferred is wollastonite having high light shielding effect and the like.

As described above, for obtaining a molded product with high reflectance, it is preferred that the fibrous reinforcing material (B) has an average fiber length (1) at or below a predetermined value. The fibrous reinforcing material (B) having an average fiber length (1) at or below a predetermined value is more likely to finely disperse in a polyester resin (A) during the production or molding of the resin composition, thereby reducing the excess stress applied to the polyester resin (A). As a result, obtainment of a molded product with high reflectance becomes more likely by suppressing the heat decomposition of the polyester resin (A) during the production or molding of the resin composition. Since the molded product containing the fibrous reinforcing material (B) having an average fiber length (1) at or below a predetermined value has high surface smoothness, the reflectance is easily enhanced.

The average fiber length (1) of the fibrous reinforcing material (B) in the polyester resin composition for a reflective material is 300 μm or less, preferably 100 μm or less, more preferably 95 μm or less, still more preferably 50 μm or less, and still more preferably 40 μm or less. When the average fiber length (1) is 300 μm or less, the excess stress applied to the polyester resin (A) during the production or molding of the resin composition becomes reduced, and the heat decomposition of the resin becomes suppressed because the fibrous reinforcing material (B) is more likely to finely disperse in a polyester resin (A) during the production or molding of the resin composition. Further, it becomes possible to increase the surface smoothness of the obtained molded product. As a result, more likely obtained is a

molded product with high reflectance. There is no limitation to the lower limit of the average fiber length (1), but 2 μm is preferred, 5 μm is more preferred, and 8 μm is still more preferred. The average fiber length (1) of 2 μm or more can impart satisfactory strength to the molded product.

For not only maintaining the average fiber length (1) of the fibrous reinforcing material (B) in the polyester resin composition for a reflective material at or below a predetermined value, but also suppressing heat decomposition of the resin during melt kneading, it is preferred that the fibrous reinforcing material (B) before melt kneading (i.e., raw material before blending into a resin composition) does not contain any fibrous reinforcing material having an average fiber length of more than 300 μm. For example, when a raw material before blending into a resin composition is glass fiber having an average fiber length of 3 mm, stress is applied to the glass fiber by kneading or the like during the production of pellets or molding, and as a result, the average fiber length (1) of the glass fiber in the pellets or a molded product may become 300 μm or less by chance. In this case, the polyester resin (A) often suffers excess stress during the production of pellets or molding, and heat decomposition of the resin may occur. Therefore, the average fiber length of the fibrous reinforcing material (B) at a raw material stage is preferably 300 μm or less, more preferably 100 μm or less, still more preferably 80 μm or less, yet more preferably 60 μm or less, and particularly preferably 50 μm or less.

For easily and finely dispersing the fibrous reinforcing material (B) during the production or molding of the resin composition, and increasing surface smoothness of the molded product, the average fiber diameter (d) of the fibrous reinforcing material (B) in the polyester resin composition for a reflective material is preferably at or below a predetermined value, and in particular, 0.05 to 18 μm is preferred and 2 to 6 μm is more preferred. Adjustment of an average fiber diameter (d) to a predetermined value or more may suppress breakage or the like of the fibrous reinforcing material (B) during the production or molding of the resin composition. The fibrous reinforcing material (B) having an average fiber diameter (d) at or below a predetermined value is likely to impart high surface smoothness to a molded product, thereby achieving high reflectance.

The average fiber length (1) and average fiber diameter (d) of a fibrous reinforcing material (B) in a polyester resin composition for a reflective material can be measured by the following steps.

1) The fibrous reinforcing material (B) is separated from the polyester resin composition for a reflective material (e.g., in a form of a compound such as pellets). The separation of the fibrous reinforcing material (B) from the pellets is performed by dissolving the pellets in hexafluoroisopropanol/chloroform solution (0.1/0.9 vol%), followed by filtration of the resultant solution to thereby obtain filtration residues.
2) 100 arbitrary fibers of the fibrous reinforcing material (B) obtained from the residues obtained in the above step 1) are observed under a scanning electron microscope (SEM) (S-4800 manufactured by Hitachi, Ltd.) at a magnification of 50, and the fiber length and fiber diameter of each fiber are measured. The average of the measured fiber lengths is used as the average fiber length (1), and the average of the measured fiber diameters is used as the average fiber diameter (d).

The aspect ratio (1/d) of the fibrous reinforcing material (B) which is obtained by dividing the average fiber length (1) by the average fiber diameter (d) is preferably 2 to 20, more preferably 4 to 16, still more preferably 7 to 12, and particularly preferably more than 10 to 12 or less. When the aspect ratio is 2 or more, it becomes easy to impart at least a certain level of strength or rigidity to the molded product. When the aspect ratio is 20 or less, it becomes easy for the fibrous reinforcing material (B) to finely disperse, and for the molded product to have high surface smoothness.

The content of the fibrous reinforcing material (B) in the polyester resin composition for a reflective material is 5 to 30 mass%, preferably 7 to 28 mass%, and more preferably 10 to 25 mass%, relative to the total amount of the polyester resin (A), the fibrous reinforcing material (B), and a white pigment (C). When the content of the fibrous reinforcing material (B) is 5 mass% or more, it becomes possible to impart satisfactory strength to the molded product and to preferably suppress the heat decomposition of the polyester resin (A) during molding or the like. Accordingly, the initial reflectance of the molded product is likely to become increased. When the content of the fibrous reinforcing material (B) is 30 mass% or less, moldability is less likely to be impaired, and it becomes possible to suppress the lowering of reflectance due to the hue of the fibrous reinforcing material (B) itself.

The content of the fibrous reinforcing material (B) relative to the polyester resin (A) can be preferably 10 to 50 mass%, and more preferably 15 to 40 mass%.

1-3. White Pigment (C)

The white pigment (C) in the polyester resin composition of the present invention for a reflective material may be any substance as long as it can whiten the resin composition and improve the light-reflective function. Specifically, the refractive index of the white pigment (C) is preferably 2.0 or more. The upper limit of the refractive index of the white pigment (C) can be, e.g., 4.0. Examples of the white pigments (C) include titanium oxide, zinc oxide, zinc sulfide, lead white, zinc sulfate, barium sulfate, calcium carbonate, and aluminium oxide. These white pigments (C) may be used

individually or in combination.

Among these, titanium oxide is preferred because a molded product of the polyester resin composition for a reflective material containing titanium oxide as the white pigment (C) has high reflectance, concealability, and the like. The titanium oxide is preferably a rutile-type titanium oxide. The average particle diameter of the titanium oxide is preferably 0.1 to 0.5 μm, and more preferably 0.15 to 0.3 μm.

The white pigment (C) may be treated with a silane coupling agent, titanium coupling agent, or the like. For example, the white pigment (C) may be subjected to a surface treatment with a silane compound such as vinyltriethoxysilane, 2-aminopropyltriethoxysilane, or 2-glycidoxypropyltriethoxysilane.

From the view point of achieving uniform reflectance or the like, it is preferred that the white pigment (C) has a small aspect ratio, i.e., nearly spherical shape.

The content of the white pigment (C) in the polyester resin composition for a reflective material is 5 to 50 mass%, preferably 10 to 50 mass%, more preferably 10 to 40 mass%, and still more preferably 10 to 30 mass%, relative to the total amount of the polyester resin (A), the fibrous reinforcing material (B), and the white pigment (C). When the content of the white pigment (C) is 5 mass% or more, it is more likely to obtain satisfactory whiteness, and to increase reflectance of the molded product. When the content of the white pigment (C) is 50 mass% or less, moldability is less likely to be impaired. Particularly, using a fibrous reinforcing material (B) having an average fiber length (1) at or below a predetermined value enables obtaining high reflectance and therefore, the content of the white pigment (C) can be reduced as compared to a conventional compound.

The content of the white pigment (C) relative to the polyester resin (A) can be preferably 20 to 70 mass%, and more preferably 35 to 65 mass%.

1-4. Other Components (D)

The polyester resin composition of the present invention for a reflective material may contain an arbitrary component in accordance with applications as long as the effect of the present invention is not impaired. Examples of arbitrary components include antioxidants (such as phenol-based, amine-based, sulfur-based, and phosphorus-based antioxidants), heat-resistant stabilizers (such as lactone compounds, vitamin E, hydroquinones, copper halides, and iodine compounds), light stabilizers (such as benzotriazoles, triazines, benzophenones, benzoates, hindered amines, and oxanilides), other polymers (such as polyolefins, ethylene-propylene copolymers, olefin copolymers such as an ethylene-1-butene copolymer, olefin copolymers such as a propylene-1-butene copolymer, polystyrenes, polyamides, polycarbonates, polyacetals, polysulfones, polyphenylene oxides, fluororesins, silicone resins, and LCP), flame retardants (such as bromine-based, chlorine-based, phosphorus-based, antimony-based, and inorganic flame retardants), fluorescent brightening agents, plasticizers, thickeners, antistatic agents, release agents, pigments, crystal nucleating agents, and various conventional compounding agents.

The polyester resin composition of the present invention for a reflective material preferably contains an antioxidant. Preferred examples of the antioxidants include hindered phenols such as pentaerythritol tetrakis[3-(3,5-di-tert-butyl-4-hydroxyphenyl)propionate] and compounds represented by the following formula (1), and phosphorus-based antioxidants having $P(OR)_3$ structure (where R is an alkyl group, alkylene group, aryl group, arylene group or the like). These antioxidants are preferred because they suppress decomposition reactions of the polyester resin (A) in a high temperature atmosphere (in particular, under conditions such that the temperature exceeds 250°C as in reflow soldering), and they are more likely to suppress the discoloration of the resin composition. Among the above mentioned antioxidants, the compounds represented by the following general formula (1) are preferred.

General Formula (1)

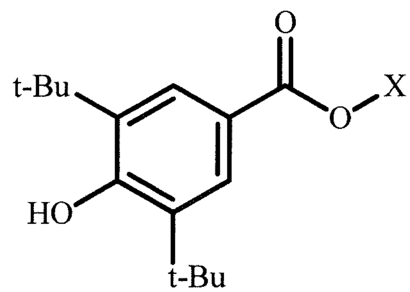

In general formula (1), X is an organic group. The organic group X is a substituted or unsubstituted $C_1$-$C_{20}$ alkyl group, a substituted or unsubstituted cyclohexyl group, or a substituted or unsubstituted $C_6$-$C_{20}$ aryl group. Examples

of the substituted or unsubstituted $C_1$-$C_{20}$ alkyl groups include methyl group, ethyl group, n-propyl group, n-octyl group, n-tetradecyl group, and n-hexadecyl group. Examples of the substituted or unsubstituted $C_6$-$C_{20}$ aryl groups include 2,4-di-t-butylphenyl group and 2,4-di-t-pentylphenyl group. A substituent attached to the alkyl group, cyclohexyl group, or aryl group is preferably a member selected from the group consisting of a $C_1$-$C_{12}$ alkyl group, a $C_6$-$C_{12}$ aryl group, hydroxyl group, methoxy group, and oxadiazole group.

An example of the compound represented by general formula (1) is the following compound.

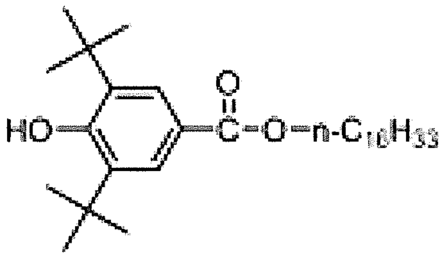

Molecular Weight 474.8

The amount of the antioxidant is preferably 10 mass% or less, more preferably 5 mass% or less, and still more preferably 1 mass% or less, relative to the total amount of the resin components containing the polyester resin (A) (preferably consisting of polyester resin (A)).

When the polyester resin composition of the present invention for a reflective material is used in combination with other components, the selection of the above-mentioned additive may become important in some cases. For example, when the other components combined include a catalyst or the like, it is preferred to avoid the use of an additive containing a component or element which may act as a catalyst poison. Examples of such additives which are preferably avoided include compounds containing sulfur.

1-5. Physical Properties

(Flowability)

The polyester resin composition of the present invention for a reflective material can have satisfactory moldability. Specifically, the flow length of the polyester resin composition for a reflective material during injection molding under below-mentioned conditions is preferably 30 mm or more, more preferably 31 mm or more.

Injection molding apparatus: Tuparl TR40S3A, Sodick Co., Ltd.
Injection set pressure: 2,000 kg/cm$^2$
Cylinder set temperature: melting point (Tm) + 10 °C
Mold temperature: 30 °C

The flowability of the polyester resin composition of the present invention for a reflective material can be adjusted by changing the content of the fibrous reinforcing material (B) or the white pigment (C), or the average fiber length (1) or the aspect ratio (1/d) of the fibrous reinforcing material (B). The flowability can be increased, for example, by changing the content of the fibrous reinforcing material (B) or the white pigment (C) to a predetermined content or less, and by using the fibrous reinforcing material (B) having an average fiber length (1) or aspect ratio (1/d) at or below a predetermined value.

2. Method of Producing Polyester Resin Composition for Reflective Material

The polyester resin composition of the present invention for a reflective material can be produced by a conventional method, such as a method in which the above components are mixed together by means of a Henschel mixer, a V-blender, a ribbon blender, a tumbler blender or the like to thereby obtain a mixture, or a method in which the thus obtained mixture is further melt kneaded by means of a single-screw extruder, a multi-screw extruder, a kneader, a Banbury mixer, or the like, followed by granulation or pulverization.

The polyester resin composition of the present invention for a reflective material may be preferably in the form of a compound such as a pellet which is obtained by mixing the above components by means of a single-screw extruder, a multi-screw extruder or the like, melt kneading the resultant mixture, and granulating or pulverizing the melt-kneaded mixture. The compound is suitably used as a molding material. The melt kneading is preferably performed at a temperature

which is 5 to 30 °C higher than the melting point of the polyester (A). The lower limit of the melt-kneading temperature is preferably 255 °C and more preferably 275 °C, and the upper limit is preferably 360 °C, and more preferably 340 °C.

3. Reflector

The reflector of the present invention may be a molded product of the polyester resin composition of the present invention for a reflective material.

With respect to the fibrous reinforcing material (B) contained in the molded product of the polyester resin composition of the present invention for a reflective material, each of the average fiber length (1), average fiber diameter (d) and aspect ratio (1/d) may be in the same range as that of the fibrous reinforcing material (B) in the polyester resin composition for a reflective material.

The average fiber length (1) and average fiber diameter (d) of the fibrous reinforcing material (B) contained in the molded product can be measured in the same manner as described above. Specifically, the steps are as follows.

1) The molded product is dissolved in hexafluoroisopropanol/chloroform solution (0.1/0.9 vol%), and then the resultant solution is filtered to thereby obtain filtration residues.

2) 100 arbitrary fibers of the fibrous reinforcing material (B) obtained from the residues obtained in step 1) are observed under a scanning electron microscope (S-4800 manufactured by Hitachi, Ltd.) at a magnification of 50, and the fiber length and fiber diameter of each fiber are measured. The average of the measured fiber lengths is used as the average fiber length (1) and the average of the measured fiber diameters is used as the average fiber diameter (d), both for the fibrous reinforcing material (B) contained in the molded product.

For a molded product to function satisfactorily as a reflector, it is preferred that the molded product of the polyester resin composition of the present invention for a reflective material has light reflectance at a wavelength of 450 nm of 90% or more, and more preferred is 94% or more. Reflectance can be measured using CM3500d manufactured by KONICA MINOLTA, INC. The thickness of the molded product at the time of measurement may be 0.5 mm. For the initial reflectance to be at least a predetermined value, it is preferred to suppress the heat decomposition of the polyester resin (A) during molding or the like, and more preferred to adjust the average fiber length (1) of the fibrous reinforcing material (B) to a predetermined value or lower.

It is preferred that the molded product of the polyester resin composition of the present invention for a reflective material suffers only a small reduction of reflectance even when heat and/or light is applied thereto. Specifically, the light reflectance of the molded product at a wavelength of 450 nm as measured after heating at 150 °C for 168 hours can be, e.g., 90% or more, and preferably 93% or more. The light reflectance of the molded product at a wavelength of 450 nm as measured after UV irradiation at 16 $mW/cm^2$ for 500 hours can be, e.g., 80% or more, and preferably 87% or more. The thickness of the molded product at the time of measurement may be 0.5 mm. The light reflectance of the molded product measured after storage at 170 °C for 2 hours, followed by reflow soldering under the conditions such that the surface temperature becomes 260 °C, can be , e.g., 89% or more, and preferably 91% or more.

The reflector of the present invention may be a casing or housing having at least a light-reflecting surface. The light-reflecting surface may be a planar surface, a curved surface, or a spherical surface. For example, the reflector may be a molded product having a reflecting surface in the shape of a box, a case, a funnel, a bowl, a parabola, a cylinder, a circular cone, a honeycomb, or the like.

The reflector of the present invention is used for various light sources such as an organic EL and a light-emitting diode element (LED). Among these, the use as a reflector for a light-emitting diode element (LED) is preferred, and as a reflector for a light-emitting diode element (LED) applicable for surface mounting is more preferred.

The reflector of the present invention can be obtained by shaping the polyester resin composition of the present invention for a reflective material into a desired shape by heat molding, such as injection molding, metal insert molding (particularly hoop molding or the like), melt molding, extrusion molding, inflation molding, or blow molding.

Since the fibrous reinforcing material (B) in the polyester resin composition of the present invention for a reflective material has an average fiber length (1) at or below a predetermined value, the fibrous reinforcing material (B) can finely disperse in the polyester resin (A) during the production or molding of the resin composition. As a result, heat decomposition of the polyester resin (A) can be suppressed during the production or molding of the resin composition and a reflector having high reflectance with only small discoloration can be obtained.

An LED package provided with the reflector of the present invention may have, for example, a housing which is molded on a substrate and which has a space for mounting an LED, an LED mounted inside the space, and a transparent sealing member sealing the LED. Such an LED package may be produced by the following steps: 1) molding a reflector on a substrate to thereby obtain a housing; 2) disposing an LED inside the housing and electrically connecting the LED with the substrate; and 3) sealing the LED with a sealant.

During sealing, the LED package is heated at 100 to 200 °C for thermally curing the sealant. Further, during

reflow soldering for mounting the LED package on a printed substrate, the LED package is exposed to a high temperature which is 250 °C or higher. Since the reflector of the present invention is a molded product of the above polyester resin composition for a reflective material, the reflector can maintain high reflectance even after exposure to high-temperature heat in these steps. The reflector can, needless to say, maintain high reflectance even when exposed to light (such as visible light and ultraviolet light) and heat generated from the LED for a long time under the operating environment.

The reflector of the present invention can be used for various applications, for example, for various electric electronic components, interior illumination, exterior illumination, and automobile illumination.

Examples

Hereinafter, the present invention is described with reference to Examples, which however shall not be construed as limiting the scope of the present invention.

1. Preparation of Materials

<Polyester Resin (A)>

A polyester resin (A) was prepared according to the following method.

106.2 parts by mass of dimethyl terephthalate and 94.6 parts by mass of 1,4-cyclohexanedimethanol (cis/trans ratio: 30/70) (manufactured by Tokyo Chemical Industry Co., Ltd.) were mixed together. To the resultant mixture was added, 0.0037 parts by mass of tetrabutyl titanate, and the temperature was elevated from 150 °C to 300 °C over 3.5 hours to effect an ester exchange reaction.

At the completion of the above ester exchange reaction, 0.066 parts by mass of magnesium acetate tetrahydrate dissolved in 1,4-cyclohexanedimethanol was added to the reaction mixture, followed by an introduction of 0.1027 parts by mass of tetrabutyl titanate, thereby effecting a polycondensation reaction. During the polycondensation reaction, pressure was gradually reduced from normal pressure to 1 Torr over 85 minutes, and at the same time, the temperature was elevated to a predetermined polymerization temperature of 300 °C. Agitation of the mixture was continued while maintaining the temperature and pressure, and the reaction was terminated when agitation torque reached a predetermined value. The thus obtained polymer was taken out, and subjected to a solid phase polymerization at 260°C and 1 Torr or less for 3 hours, thereby obtaining a polyester resin (A).

The obtained polyester resin (A) had the intrinsic viscosity [η] of 0.6 dl/g and the melting point of 290 °C. The intrinsic viscosity [η] and melting point were measured by the below-mentioned methods.

(Intrinsic Viscosity)

The obtained polyester resin (A) was dissolved in a mixed solvent of 50/50 mass% phenol and tetrachloroethane to obtain a sample solution. The falling time (seconds) of the obtained sample solution was measured using an Ubbelohde viscometer at 25 °C ± 0.05 °C, and the intrinsic viscosity [η] was calculated by applying the results to the following equations.

$$[\eta] = \eta SP/[C(1 + k\eta SP)]$$

[η]: intrinsic viscosity (dl/g)
ηSP: specific viscosity
C: sample concentration (g/dl)
t: falling time (seconds) of sample solution
t0: falling time (seconds) of a solvent
k: constant (slope determined by measuring the specific viscosity of (3 or more) samples having different solution concentrations, and plotting ηSP/C on the abscissa against the solution concentration of the ordinate)

$$\eta SP = (t - t0)/t0$$

(Melting Point)

The melting point of the polyester (A) was measured in accordance with JIS-K7121. Specifically, X-DSC7000

(manufactured by SII) was used as a measuring apparatus. A sample of the polyester resin (A) sealed in a pan for DSC measurement was set in the apparatus, and the temperature was elevated to 320 °C at a temperature-elevation rate of 10 °C/min in a nitrogen atmosphere, maintained thereat for 5 minutes, and then lowered to 30 °C at a temperature-lowering rate of 10 °C/min. The peak top temperature of an endothermic peak during the temperature elevation was used as a "melting point."

<Fibrous Reinforcing Material (B)>

(B-1) Wollastonite: NYGLOS 4W (average fiber length: 50 μm, average fiber diameter: 4.5 μm, aspect ratio: 11), manufactured by TOMOE Engineering Co., Ltd.
(B-2) Wollastonite: NYGLOS 8 (average fiber length: 136 μm, average fiber diameter: 8 μm, aspect ratio: 17), manufactured by TOMOE Engineering Co., Ltd.
(B-3) Glass Fiber: Milled Fiber EFDE50-01 (average fiber length: 50 μm, average fiber diameter: 6 μm, aspect ratio: 8), manufactured by Central Glass Fiber Co., Ltd.

<Comparative Reinforcing Material>

(R-1) Wollastonite: NYAD G (average fiber length: 600 μm, average fiber diameter: 40 μm, aspect ratio: 15), manufactured by TOMOE Engineering Co., Ltd.
(R-2) Glass Fiber: ECS03T-790DE (average fiber length: 3 mm, average diameter (average fiber diameter): 6 μm, aspect ratio: 500), manufactured by Nippon Electric Glass Co., Ltd.

The average fiber length and average fiber diameter of the raw material fibrous reinforcing materials (B) and comparative reinforcing materials were measured as follows. The fiber length and fiber diameter of each of 100 arbitrary fibers of the fibrous reinforcing material (B) were measured using a scanning electron microscope (SEM) at a magnification of 50. The average of the obtained fiber lengths was used as the average fiber length, and the average of the obtained fiber diameters was used as the average fiber diameter. The aspect ratio was determined by dividing the average fiber length by the average fiber diameter.

<White Pigment (C)>

Titanium oxide (in a powder form, average particle diameter*b: 0.21 μm)

*b: The average particle diameter of titanium oxide was determined from a transmission electron micrograph by an image analysis using an image analyzer (LUZEX IIIU).

<Antioxidant (D)>

(D-1) Irganox1010 (manufactured by BASF): Pentaerythritol tetrakis[3-(3,5-di-tert-butyl-4-hydroxyphenyl)propionate]
(D-2) KEMISORB114 (Chemipro Kasei Kaisha, Ltd): A compound represented by the following formula:

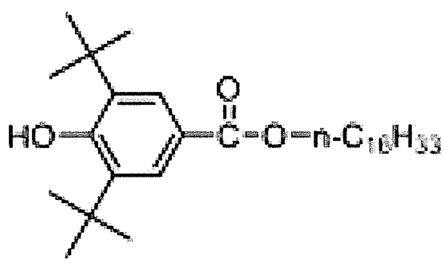

Molecular Weight 474.8.

2. Production of Polyester Resin Composition for Reflective Material

[Example 1]

Using a tumbler blender were mixed, 54.5 parts by mass of the above prepared polymer as a polyester resin (A), 10 parts by mass of wollastonite (B-1) as a fibrous reinforcing materials (B), 35 parts by mass of the above titanium oxide as a white pigment (C), and 0.5 parts by mass of Irganox1010 (D-1) (manufactured by BASF) as an antioxidant (D). The resultant mixture was melt kneaded by means of a twin-screw extruder (TEX30$\alpha$, manufactured by Japan Steel Works, Ltd.) at a cylinder temperature of 300°C, and the kneaded mixture was extruded into a strand. The extruded strand was cooled in a water tank, pulled out and cut using a pelletizer, thereby obtaining a pellet-shaped polyester resin composition for a reflective material. The compoundability of the composition was confirmed to be satisfactory.

[Examples 2 to 5 and Comparative Examples 1 to 4]

Pellet-shaped polyester resin compositions were obtained in substantially the same manner as in Example 1 except that the composition ratio of each resin composition was changed as shown in Tables 1 and 2.

For each of the resin compositions obtained in Examples and Comparative Examples, various types of reflectance of the molded product and flowability were evaluated by the following methods.

<Reflectance>

(Initial Reflectance)

Each of the obtained pellet-shaped polyester resin compositions was injection molded using the below-mentioned molding machine under the below-mentioned conditions, thereby preparing a test specimen having a length of 30 mm, a width of 30 mm, and a thickness of 0.5 mm. The reflectance of the prepared test specimen within a wavelength range of 360 nm to 740 nm was determined using CM3500d manufactured by KONICA MINOLTA, INC. The reflectance at 450 nm was used as a representative value for the initial reflectance.

Molding machine: SE50DU manufactured by Sumitomo Heavy Industries, Ltd.
Cylinder temperature: melting point (Tm) + 10°C
Mold temperature: 150 °C

(Reflectance after Reflow Test)

The test specimen used for measuring the initial reflectance was placed in a 170 °C oven for 2 hours. Subsequently, using an air reflow soldering apparatus (AIS-20-82-C manufactured by Eightech Tectron Co., Ltd.), the test specimen was subjected to a heat treatment with a temperature profile in which the surface temperature of the test specimen was elevated to 260 °C and maintained thereat for 20 seconds (similar to the heat treatment for reflow soldering). After slowly cooling the resultant test specimen, the reflectance was measured in the same manner as the initial reflectance, and the measured value was used as the reflectance after the reflow test.

(Reflectance after Heating)

The test specimen used for measuring the initial reflectance was placed in a 150 °C oven for 168 hours. Subsequently, the reflectance of the resultant test specimen was measured in the same manner as the initial reflectance, and the measured value was used as the reflectance after heating.

(Reflectance after Ultraviolet Ray (UV) Irradiation)

The test specimen used for measuring the initial reflectance was placed in the below-mentioned UV irradiator for 500 hours. Subsequently, the reflectance of the resultant test specimen was measured in the same manner as the initial reflectance, and the measured value was used as the reflectance after UV irradiation.

UV irradiator: SUPER WIN MINI, manufactured by DAYPLA WINTES CO., LTD.
Output: 16 $mW/cm^2$

<Flowability>

Each of the obtained pellet-shaped polyester resin compositions was injection molded under the below-mentioned conditions using a bar-flow mold having a width of 10 mm and a thickness of 0.5 mm to thereby measure the flow length (mm) of the resin in the mold.

Injection molding machine: Tuparl TR40S3A, Sodick Co., Ltd.
Injection set pressure: 2,000 $kg/cm^2$
Cylinder set temperature: melting point (Tm) + 10 °C
Mold temperature: 30 °C

<Surface Smoothness>

The test specimen used for measuring the initial reflectance was visually observed and evaluated based on the following criteria.

A: The surface is free of unevenness and is smooth

B: The surface is uneven and not smooth

Further, for each of Examples 1 to 5 and Comparative Examples 1 to 3, the average fiber length and average fiber diameter of the fibrous reinforcing material (B) contained in the pellet-shaped polyester resin composition and the molded product were measured individually, and the resin composition and the molded product were observed under SEM.

<Measurement of Average Fiber Length (1) and Average Fiber Diameter (d) of Fibrous Reinforcing Material (B) in the Resin Composition and in the Molded Product>

(A) Pellet-shaped Polyester Resin Composition

1) The pellet-shaped polyester resin composition of each of Examples 1 and 3 was dissolved in hexafluoroisopropanol/chloroform solution (0.1/0.9 vol%), and the resultant solution was filtered to obtain filtration residue.
2) 100 arbitrary fibers of the fibrous reinforcing material (B) obtained from the residue were observed under a scanning electron microscope (S-4800 manufactured by Hitachi, Ltd.) at a magnification of 50, and the fiber length and fiber diameter of each fiber were measured. The average of the measured fiber lengths was used as "the average fiber length (1) in the resin composition," and the average of the measured fiber diameters was used as "the average fiber diameter (d) in the resin composition."

(B) Molded Product

The pellet-shaped polyester resin composition of each of Examples 1 and 3 was injection molded using the below-mentioned molding machine under the below-mentioned conditions, thereby preparing a test specimen having a length of 30 mm, a width of 30 mm, and a thickness of 0.5 mm.

Molding machine: SE50DU manufactured by Sumitomo Heavy Industries, Ltd.
Cylinder temperature: Melting point (Tm) + 10 °C
Mold temperature: 150 °C

In the same manner as in step 1) of (A) above, the obtained test specimen was dissolved in hexafluoroisopropanol/chloroform solution (0.1/0.9 vol%), and the resultant solution was filtered to obtain filtration residues. Subsequently, the fiber length and fiber diameter of each of 100 arbitrary fibers of the fibrous reinforcing material (B) obtained from the residues were measured in the same manner as in step 2) of (A) above. The average of the measured fiber lengths was used as "the average fiber length (1) in the molded product," and the average of the measured fiber diameters was used as "the average fiber diameter (d) in the molded product."

<Observation under SEM>

With respect to the pellet-shaped polyester resin composition and a molded product thereof of each of Example 1 and Comparative Example 1, a portion was cut out by argon ion beam processing and observed under a scanning electron microscope (S-4800 manufactured by Hitachi, Ltd.). As the molded product, the above-mentioned test specimen used for measuring the average fiber length and average fiber diameter of the fibrous reinforcing material (B) in the molded product was used. An SEM image of the pellet-shaped polyester resin composition of Example 1 is shown in FIG. 1A, and an SEM image of the molded product of the same resin composition is shown in FIG. 1B. An SEM image of the pellet-shaped polyester resin composition of Comparative Example 1 is shown in FIG. 2A, and an SEM image of the molded product of the same resin composition is shown in FIG. 2B.

The evaluation results of Examples 1 to 5 are shown in Table 1, and the evaluation results of Comparative Examples 1 to 4 are shown in Table 2.

[Table 1]

| | | | Unit | Ex. 1 | Ex. 2 | Ex. 3 | Ex. 4 | Ex. 5 |
|---|---|---|---|---|---|---|---|---|
| Composition | Polyester Resin (A) | | parts by mass | 54.5 | 54.5 | 54.5 | 54.5 | 54.5 |
| | Fibrous Reinforcing Material (B) | Type | - | B-1 | B-2 | B-1 | B-1 | B-3 |
| | | Fiber Length (Raw material stage) | μm | 50 | 136 | 50 | 50 | 50 |
| | | Content | parts by mass | 10 | 10 | 20 | 10 | 10 |
| | White Pigment (C) | | parts by mass | 35 | 35 | 25 | 35 | 35 |
| | Antioxidant (D) | (D-1) | parts by mass | 0.5 | 0.5 | 0.5 | 0 | 0.5 |
| | | (D-2) | parts by mass | 0 | 0 | 0 | 0.5 | 0 |

(continued)

| | | | Unit | Ex. 1 | Ex. 2 | Ex. 3 | Ex. 4 | Ex. 5 |
|---|---|---|---|---|---|---|---|---|
| Evaluation | Reflectance | Initial | % | 95 | 94.9 | 94.3 | 95 | 94.9 |
| | | After Reflow Test | % | 93.5 | 93.3 | 93.3 | 93.5 | 92.8 |
| | | After Heating 150 °C × 168h | % | 94 | 93.4 | 93.2 | 94.4 | 93.1 |
| | | After UV Irradiation $16mW/cm^2 \times 500h$ | % | 87.3 | 87.2 | 87 | 88.9 | 87.1 |
| | Flowability | 0.5L/t (Flow length) | mm | 33 | 32 | 30 | 33 | 30 |
| | Surface Smoothness | | - | A | A | A | A | A |
| | Pellet-shaped Polyester Resin Composition (Before Molding) | Average Fiber Length (l) | μm | 23 | 90 | 23 | 23 | 28 |
| | | Average Fiber Diameter (d) | μm | 2.9 | 5.8 | 2.9 | 2.9 | 5.7 |
| | | Aspect Ratio (l/d) | - | 8 | 16 | 8 | 8 | 5 |
| | Molded Product (After Molding) | Average Fiber Length (l) | μm | 25 | 83 | 25 | 25 | 25 |
| | | Average Fiber Diameter (d) | μm | 3.1 | 5.3 | 3.1 | 3.1 | 5.6 |
| | | Aspect Ratio (l/d) | - | 8 | 16 | 8 | 8 | 4 |

[Table 2]

| | | | Unit | Comp. Ex. 1 | Comp. Ex. 2 | Comp. Ex. 3 | Comp. Ex. 4 |
|---|---|---|---|---|---|---|---|
| Composition | Polyester Resin (A) | | parts by mass | 54.5 | 34.5 | 54.5 | 54.5 |
| | Fibrous Reinforcing Material (B) | Type | - | R-2 | B-1 | R-1 | - |
| | | Fiber Length (Raw material stage) | μm | 3000 | 50 | 600 | - |
| | | Content | parts by mass | 10 | 35 | 10 | 0 |
| | White Pigment (C) | | parts by mass | 35 | 30 | 35 | 45 |
| | Antioxidant (D) | (D-1) | parts by mass | 0.5 | 0.5 | 0.5 | 0.5 |
| | | (D-2) | parts by mass | 0 | 0 | 0 | 0 |

(continued)

| | | | Unit | Comp. Ex. 1 | Comp. Ex. 2 | Comp. Ex. 3 | Comp. Ex. 4 |
|---|---|---|---|---|---|---|---|
| Evaluation | Reflectance | Initial | % | 94.2 | 91.1 | 90.1 | 94.9 |
| | | After Reflow Test | % | 91.6 | 87.7 | 86.4 | 93 |
| | | After Heating 150 °C × 168h | % | 91.7 | 88.5 | 84.6 | 93 |
| | | After UV Irradiation 16mW/cm$^2$×500h | % | 86.3 | 83.7 | 82.8 | 86.8 |
| | Flowability | 0.5L/t (Flow length) | mm | 27 | 16 | 25 | 31 |
| | Surface Smoothness | | - | B | A | B | A |
| | Pellet-shaped Polyester Resin Composition (Before Molding) | Average Fiber Length (l) | µm | 344 | 25 | 310 | - |
| | | Average Fiber Diameter (d) | µm | 5.5 | 2.8 | 37 | - |
| | | Aspect Ratio (l/d) | - | 63 | 9 | 8 | - |
| | Molded Product (After Molding) | Average Fiber Length (l) | µm | 182 | 23 | 123 | - |
| | | Average Fiber Diameter (d) | µm | 5.4 | 2.8 | 32 | - |
| | | Aspect Ratio (l/d) | - | 34 | 8 | 4 | - |

Tables 1 and 2 show that each of the compositions of Examples 1 to 5 has high initial reflectance as compared to the compositions of Comparative Examples 1 and 3. The reason for the high initial reflectance can be deduced as follows. In the compositions of Examples 1 to 5, the fibrous reinforcing material (B) used as a raw material has short average fiber length as compared to that of the compositions of Comparative Examples 1 and 3 and, therefore, the fibrous reinforcing material (B) can finely disperse in the polyester resin (A), thereby reducing the excess stress applied to the polyester resin (A) and suppressing the thermal decomposition of the polyester resin (A) during pellet production or molding.

Further, with respect to the compositions of Examples 1 to 5, the amount of reduction in reflectance after heating and that after UV irradiation are either the same level with or smaller than the respective reduction in reflectance of the composition of Comparative Example 1. As apparent from the above, in the reflector of the present invention, heat and light deterioration can also be suppressed.

Furthermore, the composition of Example 1 which used wollastonite (B-1) is likely to have higher initial reflectance and reflectance after heating as compared to the composition of Example 2 which used wollastonite (B-2). In addition, despite low content of the white pigment (C), the compositions of Examples 1 and 3 which used wollastonite (B-1) have high initial reflectance and high reflectance after heating or light irradiation as compared to the composition of Comparative Example 4 not containing a fibrous reinforcing material (B).

On the other hand, the composition of Comparative Example 2 which contains too large content of wollastonite (B-1) has low initial reflectance and moldability as compared to the composition of Example 3.

Comparison between FIGS. 1 and 2 shows that the dispersion state of the fibrous reinforcing material (B) is excellent in the compositions of Examples as compared to the compositions of Comparative Examples. As apparent from the SEM images of the pellet-shaped polyester resin composition (FIG. 1A) and the molded product thereof (FIG. 1B), the fibrous reinforcing material (B) used in Example 1 is uniformly and finely dispersed in the resin. The comparison between FIGS. 1A and 1B show that there is only a small change in the fiber length of the fibrous reinforcing material (B) before and after the molding. On the other hand, the comparison between the SEM images of the pellet-shaped polyester resin composition (FIG. 2A) and the molded product thereof (FIG. 2B) show that the fibrous reinforcing material (B) used in Comparative Example 1 is not uniformly dispersed in the resin, and voids (gaps) are formed between the fibrous reinforcing material (B) and the resin.

Furthermore, the molded product formed from the composition of Comparative Example 2 containing a polyester resin (A) and 35 mass% of wollastonite had high surface smoothness of rank A; while a molded product formed from a

composition tested independently by the present inventors, namely a composition containing a polyamide resin and 35 mass% of wollastonite, had low surface smoothness of rank B. From the above results, it was confirmed that the combination of the polyester resin (A) and wollastonite can increase surface smoothness of a molded product as compared to the combination of a polyamide resin and wollastonite. Further, it was confirmed that the molded product containing the polyester (A) has higher reflectance as compared to the molded product containing the polyamide resin which is tested independently by the present inventors. A polyamide resin may suffer discoloration by heating or light irradiation, and such discoloration is considered to be the cause of the above lowering of reflectance. The discoloration of the polyamide is suspected to be derived from a terminal amino group or an amide bond in the polyamide resin.

This application claims priority based on Japanese Patent Application No. 2014-135027, filed on June 30, 2014, the entire contents of which including the specification and the drawings are incorporated herein by reference.

Industrial Applicability

The polyester resin composition of the present invention enables a production of a reflector having high reflectance, together with reduced lowering of reflectance even after exposure to heat during production of a LED package or reflow soldering at the time of mounting, or to heat and light generated from a light source under the operating environment.

## Claims

1. A polyester resin composition for a reflective material, comprising:

    30 to 80 mass% of a polyester resin (A) which has a melting point (Tm) or a glass transition temperature (Tg) of 250°C or higher as measured by means of a differential scanning calorimeter (DSC);
    5 to 30 mass% of a fibrous reinforcing material (B) which has an average fiber length (1) of 2 to 300 μm, an average fiber diameter (d) of 0.05 to 18 μm, and an aspect ratio (1/d) of 2 to 20 which is obtained by dividing the average fiber length (1) by the average fiber diameter (d); and
    5 to 50 mass% of a white pigment (C),

    total of components (A), (B) and (C) being 100 mass%.

2. The polyester resin composition for a reflective material according to claim 1, wherein the fibrous reinforcing material (B) has the average fiber length (1) of 8 to 100 μm, the average fiber diameter (d) of 2 to 6 μm, and the aspect ratio (1/d) of 4 to 16.

3. The polyester resin composition for a reflective material according to claim 1 or 2, wherein the polyester resin (A) contains:

    a dicarboxylic acid component unit (a1) containing 30 to 100 mol% of a dicarboxylic acid component unit derived from terephthalic acid, and 0 to 70 mol% of an aromatic dicarboxylic acid component unit derived from an aromatic dicarboxylic acid exclusive of terephthalic acid; and
    a dialcohol component unit (a2) containing a $C_4$-$C_{20}$ alicyclic dialcohol component unit and/or an aliphatic dialcohol component unit.

4. The polyester resin composition for a reflective material according to claim 3, wherein the alicyclic dialcohol component unit has a cyclohexane skeleton.

5. The polyester resin composition for a reflective material according to claim 3 or 4, wherein the dialcohol component unit (a2) contains 30 to 100 mol% of a cyclohexanedimethanol component unit and 0 to 70 mol% of the aliphatic dialcohol component unit.

6. The polyester resin composition for a reflective material according to any one of claims 1 to 5, wherein the fibrous reinforcing material (B) is wollastonite.

7. The polyester resin composition for a reflective material according to any one of claims 1 to 6, wherein a content of the white pigment (C) is 10 to 40 mass% based on the total of (A), (B) and (C).

8. A reflector obtained by molding the polyester resin composition for a reflective material according to any one of

claims 1 to 7.

**9.** The reflector according to claim 8 which is a reflector for a light-emitting diode element.

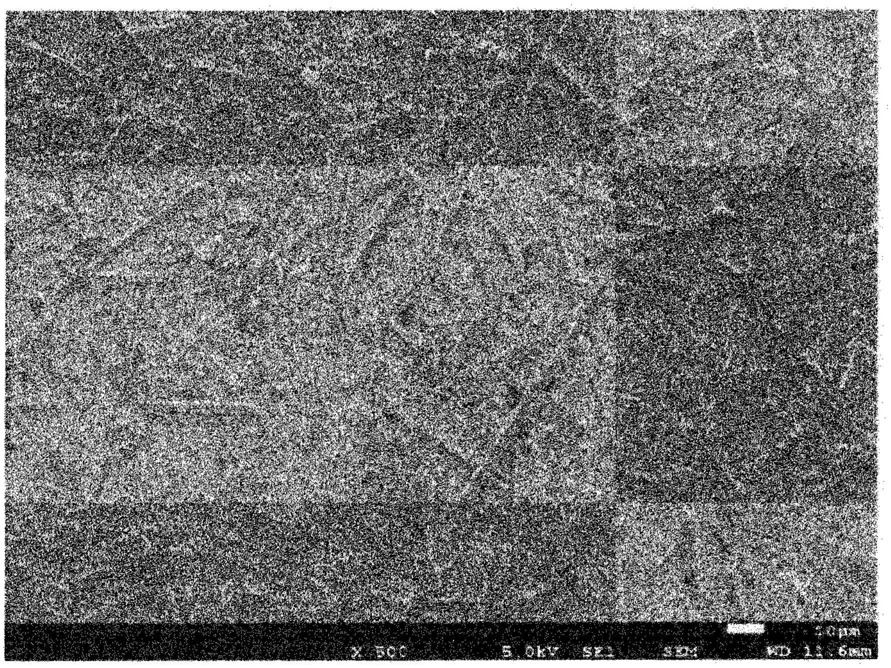


FIG. 1A

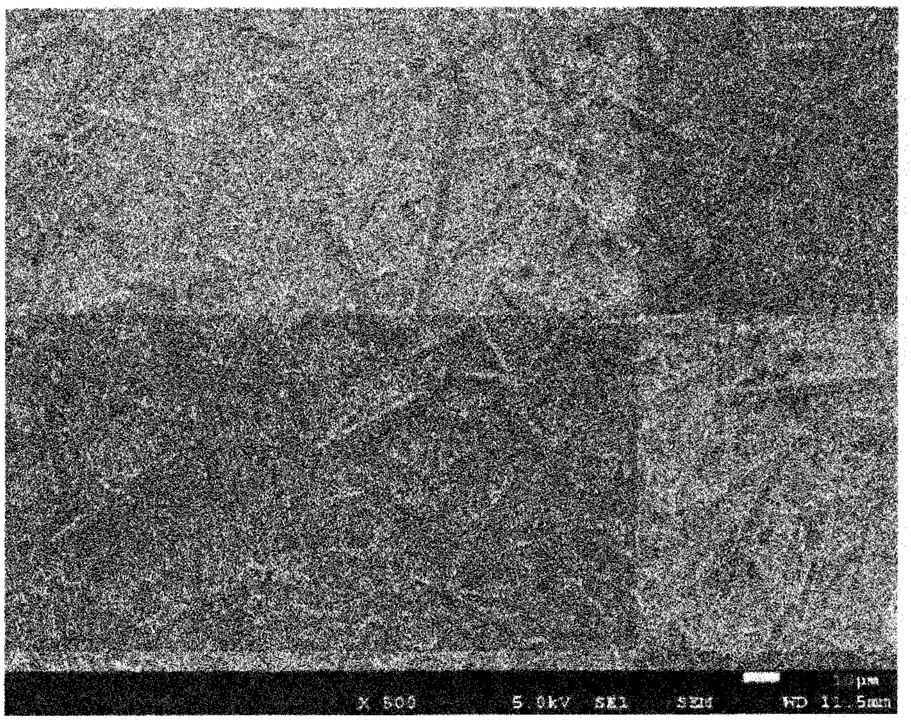


FIG. 1B

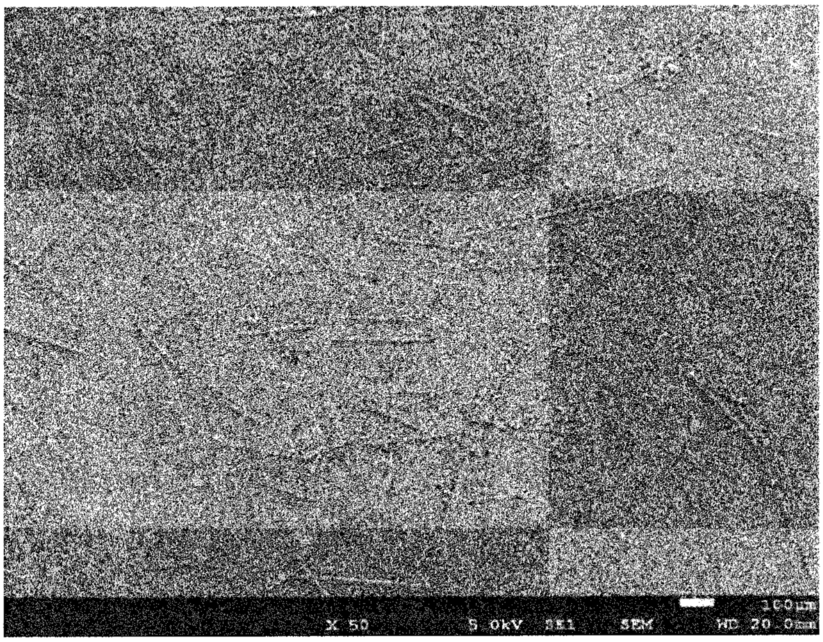
100µm
X 50 5.0kV SEI SEM WD 20.0mm

FIG. 2A

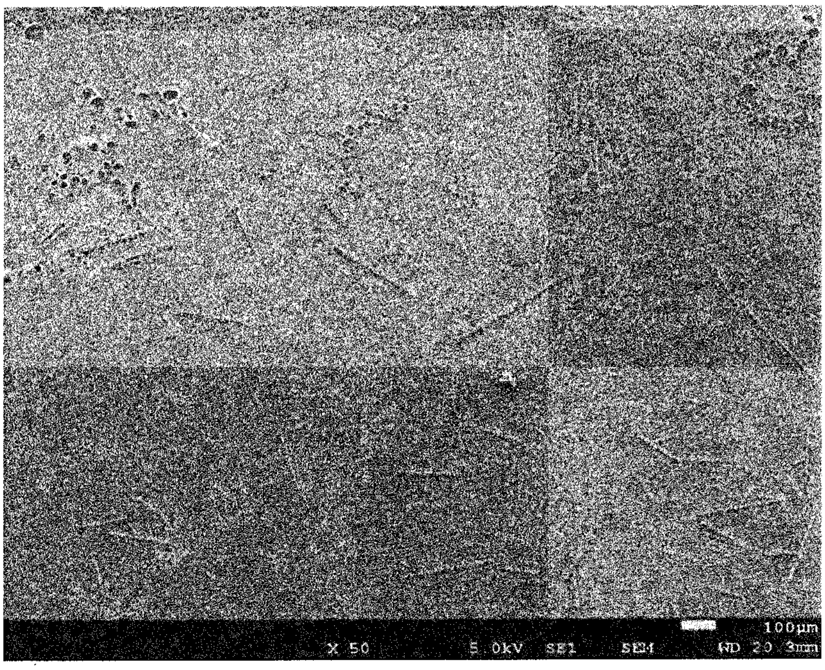
100µm
X 50 5.0kV SEI SEM WD 20.3mm

FIG. 2B

**INTERNATIONAL SEARCH REPORT**

International application No.
PCT/JP2015/003260

A. CLASSIFICATION OF SUBJECT MATTER
*C08L67/02*(2006.01)i, *C08G63/199*(2006.01)i, *C08K3/22*(2006.01)i, *C08K7/10*(2006.01)i, *H01L33/60*(2010.01)i

According to International Patent Classification (IPC) or to both national classification and IPC

B. FIELDS SEARCHED

Minimum documentation searched (classification system followed by classification symbols)
C08L67/02, C08G63/199, C08K3/22, C08K7/10, H01L33/60

Documentation searched other than minimum documentation to the extent that such documents are included in the fields searched

| | | | |
|---|---|---|---|
| Jitsuyo Shinan Koho | 1922-1996 | Jitsuyo Shinan Toroku Koho | 1996-2015 |
| Kokai Jitsuyo Shinan Koho | 1971-2015 | Toroku Jitsuyo Shinan Koho | 1994-2015 |

Electronic data base consulted during the international search (name of data base and, where practicable, search terms used)
JSTPlus/JST7580(JDreamIII)

C. DOCUMENTS CONSIDERED TO BE RELEVANT

| Category* | Citation of document, with indication, where appropriate, of the relevant passages | Relevant to claim No. |
|---|---|---|
| X | WO 2013/125453 A1 (Toyobo Co., Ltd.), 29 August 2013 (29.08.2013), claims; paragraph [0028]; examples & TW 201345971 A | 1-9 |
| P,X | JP 2014-148615 A (Toyobo Co., Ltd.), 21 August 2014 (21.08.2014), claims; paragraph [0031]; examples (Family: none) | 1-9 |
| P,X | WO 2015/004927 A1 (Panasonic Intellectual Property Management Co., Ltd.), 15 January 2015 (15.01.2015), claims; examples (Family: none) | 1-9 |

☒ Further documents are listed in the continuation of Box C. ☐ See patent family annex.

* Special categories of cited documents:
"A" document defining the general state of the art which is not considered to be of particular relevance
"E" earlier application or patent but published on or after the international filing date
"L" document which may throw doubts on priority claim(s) or which is cited to establish the publication date of another citation or other special reason (as specified)
"O" document referring to an oral disclosure, use, exhibition or other means
"P" document published prior to the international filing date but later than the priority date claimed
"T" later document published after the international filing date or priority date and not in conflict with the application but cited to understand the principle or theory underlying the invention
"X" document of particular relevance; the claimed invention cannot be considered novel or cannot be considered to involve an inventive step when the document is taken alone
"Y" document of particular relevance; the claimed invention cannot be considered to involve an inventive step when the document is combined with one or more other such documents, such combination being obvious to a person skilled in the art
"&" document member of the same patent family

| Date of the actual completion of the international search | Date of mailing of the international search report |
|---|---|
| 12 August 2015 (12.08.15) | 01 September 2015 (01.09.15) |

| Name and mailing address of the ISA/ | Authorized officer |
|---|---|
| Japan Patent Office<br>3-4-3,Kasumigaseki,Chiyoda-ku,<br>Tokyo 100-8915,Japan | Telephone No. |

Form PCT/ISA/210 (second sheet) (July 2009)

**INTERNATIONAL SEARCH REPORT**

International application No.
PCT/JP2015/003260

C (Continuation). DOCUMENTS CONSIDERED TO BE RELEVANT

| Category* | Citation of document, with indication, where appropriate, of the relevant passages | Relevant to claim No. |
|---|---|---|
| A | JP 6-200132 A (Toray Industries, Inc.), 19 July 1994 (19.07.1994), entire text; all drawings (Family: none) | 1-9 |
| A | JP 2003-147179 A (Asahi Kasei Corp.), 21 May 2003 (21.05.2003), entire text & US 2004/0198878 A1 & WO 2003/016402 A1 & DE 10297081 T | 1-9 |
| A | JP 2009-507990 A (E.I. Du Pont de Nemours & Co.), 26 February 2009 (26.02.2009), entire text & US 2007/0213458 A1 & WO 2007/033129 A2 & EP 1925038 A2 | 1-9 |
| A | WO 2013/18360 A1 (Mitsui Chemicals, Inc.), 07 February 2013 (07.02.2013), entire text; all drawings & JP 2013-32426 A & JP 2013-219158 A & US 2014/0167091 A1 & EP 2740766 A1 & CN 103717673 A & KR 10-2014-0041808 A & TW 201313825 A | 1-9 |

Form PCT/ISA/210 (continuation of second sheet) (July 2009)

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

### Patent documents cited in the description


- JP 2009507990 PCT
- JP 2002294070 A
- JP 2014135027 A